# EUROPEAN PATENT SPECIFICATION

(11) **EP 0 911 879 B1**
(45) Date of publication and mention of the grant of the patent: **02.01.2003**
(21) Application number: 98120016.5
(22) Date of filing: 22.10.1998
(51) Int. Cl.: H01L 27/115, H01L 21/3205

(54) **Ferroelectric device for semiconductor integrated circuit and method for manufacturing the same**
Ferroelektrisches Bauelement für integrierte Halbleiterschaltung und Verfahren zur Herstellung
Dispositif ferroélectrique pour circuit intégré semi-conducteur et méthode de fabrication

(30) Priority: 24.10.1997 JP 29304697
(43) Date of publication of application: 28.04.1999
(73) Proprietor: MATSUSHITA ELECTRIC INDUSTRIAL CO., LTD., Kadoma-shi, Osaka (JP)
(72) Inventor: Judai, Yuji, Uji-shi, Kyoto 611-0021 (JP)
(74) Representative: Grünecker, Kinkeldey, Stockmair & Schwanhäusser Anwaltssozietät

(56) References cited:
- EP-A- 0 499 433
- EP-A- 0 557 937
- EP-A- 0 642 167
- DE-A- 19 636 054
- US-A- 5 218 512

## Description

### BACKGROUND OF THE INVENTION

### 1. Field of the Invention

The present invention relates to a semiconductor device, particularly to a nonvolatile memory provided with a ferroelectric capacitor and its fabrication method according to the preamble of claim and as known from EP-A-0 557937.

### 2. Related art of the Invention

Recently, an attempt of integrating a capacitor using a ferroelectric thin film in a semiconductor device to obtain a new performance has been positively performed. This is because a ferroelectric thin film has a dielectric constant one place or more higher than that of a conventional silicon oxide film or silicon nitride film and is advantageous for high integration and refining, and moreover the ferroelectric thin film holds electric charges even for a voltage of 0 depending on the material and makes it possible to easily realize a nonvolatile memory.

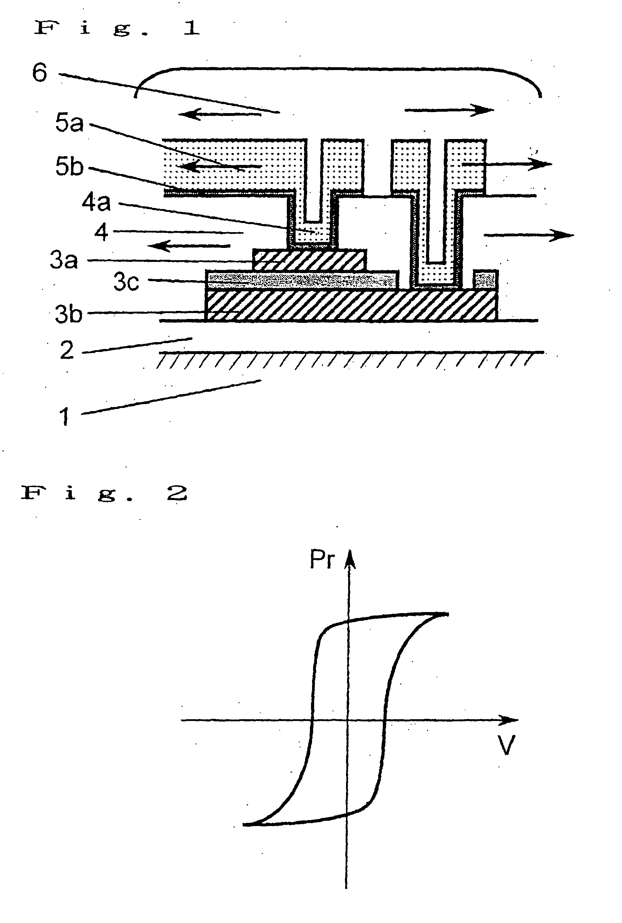

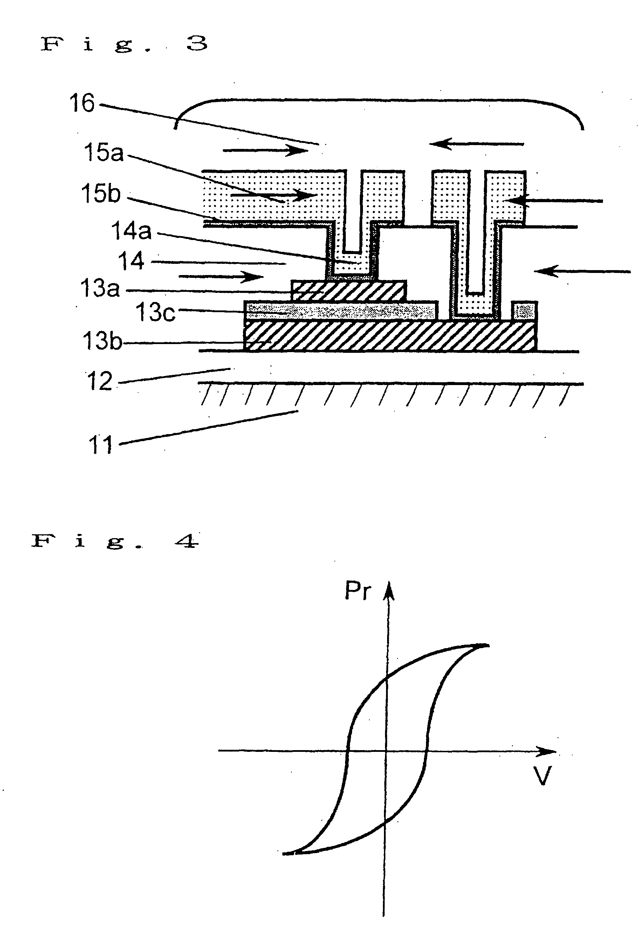

FIG. 3 shows a sectional view of a semiconductor device in which a ferroelectric capacitor is integrated in accordance with the prior art. In FIG. 3, the ferroelectric capacitor is formed with a top electrode 13a, a bottom electrode 13b, and a ferroelectric thin film 13c on a circuit board 11 comprising a conventional CMOS through an insulting film 12. An insulating film 14 is formed on the ferroelectric capacitor and the CMOS circuit board is connected by wiring films 15a and 15b through a connection hole 14a. Moreover, a surface protective film 16 is formed on the wiring films 15a and 15b to protect each element from moisture.

In this case, the insulating film 14 is formed through the plasma-excitation CVD method and the wiring films 15a and 15b are formed through the sputtering method. Moreover, the surface protective film 16 is formed through the plasma-excitation CVD method.

However, the above conventional structure has a disadvantage that characteristics of the ferroelectric thin film are deteriorated and thereby, the performance cannot be completely achieved.

A ferroelectric thin film is a material sensitive for a stress and its characteristics are greatly fluctuated due to the influence of stresses of various films formed on an upper part of a ferroelectric capacitor. In general, when an extension-directional stress is applied to the film, such characteristics as leak current and residual dielectric polarization are improved. However, when a compression-directional stress is applied to the film, its characteristics are deteriorated.

Moreover, in the case of the above semiconductor device and its fabrication method according to the prior art, each thin film formed on a ferroelectric capacitor has a compressive stress to the ferroelectric capacitor. Arrows in FIG. 3 show stress directions of thin films. Each thin film has a compression-directional stress, that is, works so as to deteriorate characteristics of a ferroelectric thin film. Therefore, as a result, a semiconductor device in which a ferroelectric thin film is integrated cannot completely show its performances.

FIG. 4 shows the polarization characteristic of a ferroelectric capacitor integrated in a semiconductor device according to the above prior art. Because of the above-described reason, the polarization characteristic originally owned by a conventional ferroelectric thin film is not shown and it is found that a polarization value Pr (also referred to as residual dielectric polarization) for a voltage of 0 has a small value.

EP-A-0 557 937 discloses a method of forming a ferroelectric capacitor for use in an integrated circuit establishing one layer over another and then annealing the structure, using an oxygen or ozone anneal, after each layer is established.

EP-A-0 499 433 discloses a semiconductor device with improved reliability wiring and method of its fabrication. This prior art reference discloses a surface protective film of SiN formed by PECVD.

### SUMMARY OF THE INVENTION

The present invention is made to solve the above conventional problems and its object is to provide a semiconductor device capable of integrating a ferroelectric thin film free from characteristic deterioration and its fabrication method. These objects are achieved by a semiconductor device having the features of claim 1 and method having the features of claims 3 - 6.

Advantageous embodiments of the invention are set forth in the dependent claims.

Moreover, the semiconductor device fabrication method of the present invention can realize a semiconductor device having the above superior performance.

### BRIEF DESCRIPTION OF THE DRAWINGS

FIG. 1 is a sectional view of the ferroelectric capacitor of the semiconductor device of an embodiment of the present invention;
FIG. 2 is an illustration showing the polarization characteristic of the ferroelectric capacitor integrated in the semiconductor device of an embodiment of the present invention;
FIG. 3 is a sectional view of the ferroelectric capacitor of a conventional semiconductor device; and
FIG. 4 is an illustration showing the polarization characteristic of the ferroelectric capacitor integrated in a conventional semiconductor device.

### PREFERRED EMBODIMENTS

Embodiments of the present invention are described below by referring to the accompanying drawings.

FIG. 1 shows a sectional view of the ferroelectric capacitor of the semiconductor device of an embodiment of the present invention. In FIG. 1, the ferroelectric capacitor is formed with a top electrode 3a, a bottom electrode 3b, and a ferroelectric thin film 3c on a circuit board 1 comprised of conventional CMOS through an insulating film 2. An insulating film 4 is formed on the ferroelectric capacitor and a CMOS circuit board is connected to wiring films 5a and 5b through a connection hole 4a in the film 4. Moreover, a surface protective film 6 is formed on the wiring films 5a and 5b to protect each element from moisture.

The semiconductor device of this embodiment is characterized in that the sum of stresses of thin films deposited on the ferroelectric capacitor is an extensional stress. In FIG. 1, arrows show stress directions of thin films. Because the sum of stresses of thin films formed on the ferroelectric capacitor has an extensional direction, an extensional stress is applied to the ferroelectric capacitor to prevent ferroelectric characteristics from deteriorating.

Moreover, the semiconductor device of this embodiment is characterized in that every thin film deposited on the ferroelectric capacitor applies an extension-directional stress to the ferroelectric capacitor. Because every thin film deposited on the ferroelectric capacitor has an extension-directional stress, an extensional stress is applied to the ferroelectric capacitor to prevent ferroelectric characteristic from deteriorating.

FIG. 2 shows the polarization characteristic of a ferroelectric capacitor integrated in the semiconductor device of the above embodiment. The polarization characteristic originally owned by a ferroelectric thin film is shown and a residual dielectric polarization Pr for a voltage of 0 also shows a large-enough value. A semiconductor device in which the ferroelectric capacitor is integrated makes it possible to completely achieve the purposed performances.

Then, a fabrication method of the semiconductor device of this embodiment is described below.

In FIG. 1, an insulating film 4 is formed on the ferroelectric capacitor through the TEOS-CVD method using TEOS activated by O₃ (ozone). An insulating film formed through plasma excitation having been used in a prior art so far has a compression-directional stress independently of conditions. Moreover, an insulating film formed through the TEOS-CVD method using TEOS activated by O₃ has an extension-directional stress and thereby, prevents characteristics of the ferroelectric capacitor from deteriorating.

Then, a TiN film is formed as a bottom-layer film 5b of a wiring film through the sputtering method to heat-treat the TiN film in a temperature range of 200 to 650°C. Though the TiN film immediately after sputtering has a compression-directional stress, the stress direction changes to an extensional direction by heat-treating the film in the temperature range of 200 to 650°C. That is, the film has a stress in a direction in which ferroelectric capacitor characteristics are not deteriorated.

Moreover, an Al film is formed as a top-layer film 5a of a wiring film through the sputtering method while heating a substrate at a high temperature of 100 to 400°C. The Al film is generally formed at room temperature of an approx. 25°C without controlling temperature. In this case, a deposited film has a compression-directional stress. However, when heating the substrate at a high temperature of 100°C or higher, a deposited Al film has an extension-directional stress. Because the Al film is melted at a temperature of 400°C or higher, it cannot be used as a wiring film. Therefore, by depositing an Al film in a temperature range of 100 to 400°C through the sputtering method, it is possible for the Al film to have a stress in a direction in which ferroelectric capacitor characteristics are not deteriorated.

Furthermore, an SiN (silicon nitride) film is deposited as a surface protective film 6 through the plasma-excitation CVD method having a RF power of 300 W or less. The stress direction of the SiN film according to plasma excitation depends on RF power. An SiN film formed by a generally-used RF power of approx. 400 W has a compression-directional stress. However, when decreasing the RF power up to 300 W, the stress becomes almost 0. The stress direction of an SiN film formed at 300 W or less reverses to an extensional direction. That is, by forming an SiN film at an RF power of 300 W or less, it is possible for the film to have a stress in a direction in which ferroelectric-capacitor characteristics are not deteriorated.

Furthermore, in the above emobdiment every insulting film, metallic wiring film, and surface protective film are described as providing a surface-directional extensional stress to the the ferroelectric thin film. However, it is possible to prevent a ferroelectric-capacitor characteristics from deteriorating compared to the case of a conventional example as long as a synthetic stress working in the surface direction of the ferroelectric thin film of a ferroelectric capacitor is an extensional stress.

Furthermore, it is described that a metallic wiring film of the present invention is constituted with top and bottom separate metallic layers in the case of this embodiment and the bottom layer is made of TiN and the top layer is made of Al. However, it is also possible to use a metallic film of only one layer. In short, as long as a synthetic stress working in the surface direction of the ferroelectric thin film of a ferroelectric capacitor is an extensional stress, the material of a metallic wiring film is not restricted.

Furthermore, for a semiconductor device of the present invention, it is described that an insulating film of the present invention is formed through the TEOS-CVD method using TEOS activated by O₃, the bottom layer of a metallic wiring film of the present invention is made of a TiN layer heat-treated in a temperature range of 200 to 650°C, the top layer of the metallic wiring film of the present invention is made of an Al layer formed through the sputtering method while heating a circuit board in a temperature range of 100 to 400°C, and a surface protective film of the present invention is formed by depositing an SiN through the plasma-excitation CVD method having an RF power of 300 W or less. However, in short, as long as a synthetic stress working in the surface direction of the ferroelectric thin film of a ferroelectric capacitor is an extensional stress, the material and forming method of each film are not restricted.

As described above, the present invention makes it possible to provide a semiconductor device capable of integrating a ferroelectric thin film free from characteristic deterioration and its fabrication method.

## Claims

1. A semiconductor device comprising
a circuit board,
a ferroelectric capacitor arranged on said circuit board, having a ferroelectric thin film (3c) and top and bottom electrodes (3a, 3b) which are formed so as to hold said ferroelectric thin film (3c),
an insulating film (4) formed on said circuit board so as to cover said ferroelectric capacitor.
a metallic wiring film (5a, 5b) formed on said insulating film so as to connect with either of said top and bottom electrodes, and
a surface protective film (6) formed so as to cover said insulating film (4) and said metallic wiring film (5a, 5b),
**characterized in that**
all of said insulating film (4), metallic wiring film (5a, 5b), and surface protective film (6) provide a surface-directional extensional stress of the ferroelectric thin film (3c) of said ferroelectric capacitor.

2. The semiconductor device according to claim 1, wherein
said metallic wiring film (5a, 5b) is constituted with two layers which are different kinds of metal.

3. A semiconductor device fabrication method of fabricating the semiconductor device of claims 1 or 2 comprising the step of:
forming said insulating film (4) on said ferroelectric capacitor by the TEOS-CVD method utilizing TEOS activated by O_{3,} whereby extensional stress is imparted to said ferroelectric thin film (3c);

4. A semiconductor device fabrication method of fabricating the semiconductor device of claims 1 or 2, wherein said metallic wiring film (5a, 5b) is constituted with two layers where a bottom layer (5b) thereof is made of TiN, and
a step of heat-treating of said formed TiN layer in a temperature range of 200 to 650°C after forming said TiN layer is included, whereby extensional stress is imparted to said ferroelectric thin film (3c).

5. A semiconductor device fabrication method of fabricating the semiconductor device of claims 1 or 2, wherein
said metallic wiring film (5a, 5b) is constituted with two layers where a top layer (5a) thereof is made of Al, and
a step of forming said Al layer through the sputtering method while heating said circuit board in a temperature range of 100 to 400°C is included, whereby extensional stress is imparted to said ferroelectric thin film (3c).

6. A semiconductor device fabrication method of fabricating the semiconductor device of claims 1 or 2, wherein
said surface protective film (6) is made of SiN, and
a step of forming said surface protective film (6) by depositing SiN through the plasma-excitation CVD method having an RF power of 300 W or less is included, whereby extensional stress is imparted to said ferroelectric thin film (3c).

## Patentansprüche

1. Halbleiter-Bauelement, das umfasst:
eine Schaltplatte,
einen auf der Schaltplatte angeordneten ferroelektrischen Kondensator mit einem ferroeiektrischen Dünnfilm (3c) und Oberseiten- und Unterseitenelektroden (3a, 3b), die so gebildet sind, dass sie den ferroelektrischen Dünnfilm (3c) halten,
einen auf der Schaltplatte gebildeten Isolierfilm (4), der den ferroelektrischen Kondensator bedeckt,
einen metallischen Verdrahtungsfilm (5a, 5b), der auf dem Isolierfilm ausgebildet, um mit der Oberseitenelektrode oder der Unterseitenelektrode verbunden zu sein, und
einen Oberflächenschutzfilm (6), der so gebildet ist, daß der Isolierfilm (4) und der metallische Verdrahtungsfilm (5a, 5b) bedeckt werden,
**dadurch gekennzeichnet, dass**
der Isolierfilm (4), der metallische Verdrahtungsfilm (5a, 5b) und der Oberflächenschutzfilm (6) alle eine Oberflächenrichtungs-Zugspannung des ferroelektrischen Dünnfilms des ferroelektrischen Kondensators erzeugen.

2. Halbleiter-Bauelement nach Anspruch 1, wobei
der metallische Verdrahtungsfilm (5a, 5b) mit zwei Schichten gebildet wird, die unterschiedliche Arten von Metall sind.

3. Halbleiter-Bauelement-Herstellungsverfahren zum Herstellen des Halbleiter-Bauelements von Anspruch 1 oder 2, umfassend den Schritt:
Bilden des Isolierfilms (4) auf dem ferroelektrischen Kondensator durch das TEOS-CVD-Verfahren unter Verwendung von TEOS aktiviert durch O₃, wodurch dem ferroelektrischen Dünnfilm (3c) eine Zugspannung verliehen wird.

4. Halbleiter-Bauelement-Herstellungsverfahren zum Herstellen des Halbleiter-Bauelements von Anspruch 1 oder 2, wobei der metallische Verdrahtungsfilm (5a, 5b) mit zwei Schichten gebildet wird, wobei eine Unterseitenschicht (5b) davon aus TiN besteht, und
ein Schritt zur Wärmebehandlung der gebildeten TiN-Schicht in einem Temperaturbereich von 200 bis 650°C nach dem Bilden der TiN-Schicht inbegriffen ist, wodurch dem ferroelektrischen Dünnfilm (3c) eine Zugspannung verliehen wird.

5. Halbleiter-Bauelement-Herstellungsverfahren zum Herstellen des Halbleiter-Bauelements von Anspruch 1 oder 2, wobei
der metallische Verdrahtungsfilm (5a, 5b) mit zwei Schichten gebildet wird, wobei eine Oberseitenschicht (5a) davon aus Al besteht, und
ein Schritt zum Bilden der Al-Schicht durch das Sputterverfahren, wobei die Schaltplatte in einem Temperaturbereich von 100 bis 400°C erhitzt wird, inbegriffen ist, wodurch dem ferroelektrischen Dünnfilm (3c) eine Zugspannung verliehen wird.

6. Halbleiter-Bauelement-Herstellungsverfahren zum Herstellen des Halbleiter-Bauelements von Anspruch 1 oder 2, wobei der Oberflächenschutzfilm (6) aus SiN besteht, und
ein Schritt zum Bilden des Oberflächenschutzfilms (6) durch Ablagem von TiN durch das Plasmastimulations-CVD-Verfahren mit einer HF-Leistung von 300 W oder weniger inbegriffen ist, wodurch dem ferroelektrischen Dünnfilm (3c) eine Zugspannung verliehen wird.

## Revendications

1. Dispositif semi-conducteur comprenant
une carte de circuit,
un condensateur ferroélectrique disposé sur ladite carte de circuit, ayant un film mince ferroélectrique (3c) et des électrodes supérieure et inférieure (3a, 3b) qui sont formées de façon à maintenir ledit film mince ferroélectrique (3c),
un film isolant (4) formé sur ladite carte de circuit de façon à recouvrir ledit condensateur ferroélectrique,
un film de câblage métallique (5a, 5b) formé sur ledit film isolant de façon à se connecter à chacune desdites électrodes supérieure ou inférieure, et
un film protecteur en surface (6) formé de façon à recouvrir ledit film isolant (4) et ledit film de câblage métallique (5a, 5b),
**caractérisé en ce que**
la totalité dudit film isolant (4), du film de câblage métallique (5a, 5b) et du film protecteur en surface (6) procure une contrainte d'extension dans le sens de la surface du film mince ferroélectrique (3c) dudit condensateur ferroélectrique.

2. Dispositif semi-conducteur selon la revendication 1, dans lequel ledit film de câblage métallique (5a, 5b) est constitué avec deux couches qui sont des types différents de métal.

3. Procédé de fabrication d'un dispositif semi-conducteur de fabrication du dispositif semi-conducteur des revendications 1 ou 2, comprenant l'étape consistant à :
former ledit film isolant (4) sur ledit condensateur ferroélectrique par le procédé TEOS-CVD utilisant TEOS activé par O₃, avec pour effet qu'une contrainte d'extension est communiquée audit film mince ferroélectrique (3c).

4. Procédé de fabrication d'un dispositif semi-conducteur de fabrication du dispositif semi-conducteur des revendications 1 ou 2, dans lequel ledit film de câblage métallique (5a, 5b) est constitué avec deux couches où une couche inférieure (5b) de celui-ci est constituée de TiN, et
une étape de traitement thermique de ladite couche de TiN formée dans une plage de températures de 200 à 650°C après formation de ladite couche de TiN est incluse, avec pour effet qu'une contrainte d'extension est communiquée audit film mince ferroélectrique (3c).

5. Procédé de fabrication d'un dispositif semi-conducteur de fabrication du dispositif semi-conducteur des revendications 1 ou 2, dans lequel
ledit film de câblage métallique (5a, 5b) est constitué avec deux couches où une couche supérieure (5a) de celui-ci est constituée de Al, et
une étape de formation de ladite couche de Al par l'intermédiaire du procédé de pulvérisation tout en chauffant ladite carte de circuit dans une plage de températures de 100 à 400°C est incluse, avec pour effet qu'une contrainte d'extension est communiquée audit film mince ferroélectrique (3c).

6. Procédé de fabrication d'un dispositif semi-conducteur de fabrication du dispositif semi-conducteur des revendications 1 ou 2, dans lequel
ledit film protecteur en surface (6) est constitué de SiN, et
une étape de formation dudit film protecteur en surface (6) en déposant SiN par l'intermédiaire du procédé CVD d'excitation au plasma ayant une puissance RF de 300 W ou moins est incluse, avec pour effet que la contrainte d'extension est communiquée audit film mince ferroélectrique (3c).
